(19) Europäisches Patentamt
European Patent Office
Office européen des brevets

(11) **EP 2 425 208 B1**

(12) **EUROPÄISCHE PATENTSCHRIFT**

(45) Veröffentlichungstag und Bekanntmachung des Hinweises auf die Patenterteilung:
**11.05.2016 Patentblatt 2016/19**

(21) Anmeldenummer: **10708754.6**

(22) Anmeldetag: **01.03.2010**

(51) Int Cl.:
***G01D 5/241*** *(2006.01)*

(86) Internationale Anmeldenummer:
**PCT/EP2010/052527**

(87) Internationale Veröffentlichungsnummer:
**WO 2010/124889 (04.11.2010 Gazette 2010/44)**

(54) **MESSELEMENT**

MEASURING ELEMENT

ÉLÉMENT DE MESURE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **29.04.2009 DE 102009002723**

(43) Veröffentlichungstag der Anmeldung:
**07.03.2012 Patentblatt 2012/10**

(73) Patentinhaber: **Robert Bosch GmbH**
**70442 Stuttgart (DE)**

(72) Erfinder: **FRANKE, Axel**
**71254 Ditzingen (DE)**

(56) Entgegenhaltungen:
**EP-A1- 0 693 672     WO-A1-2005/080921**
**US-A- 5 457 368**

EP 2 425 208 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung betrifft ein Messelement. Insbesondere betrifft die Erfindung ein mikromechanisches Messelement mit einem elektrischem Ausgangssignal.

Stand der Technik

Mikromechanische Messelemente werden in Sensoren für verschiedenste Anwendungsbereiche eingesetzt. Beispielsweise können Beschleunigungs-, Drehraten- oder Drucksensoren mikromechanisch aufgebaut werden. Dabei umfasst ein solches Messelement sowohl mechanische als auch elektrische Strukturen, die eine ähnliche Größenordnung aufweisen können und miteinander ein integriertes, mikro-elektromechanisches System bilden (Micro-Electro-Mechanical System, MEMS). Gelegentlich umfassen solche mikro-elektromechanischen Systeme auch einen Aktuator für Teile der mechanischen Strukturen, beispielsweise in Drehratensensoren, in denen eine auf eine bewegte Masse wirkende Kraft bestimmt werden soll. Auch ein mikro-elektromechanischer Resonator kann einen solchen Antrieb umfassen.

In einer Form mikro-elektromechanischer Messelemente wird eine relative Auslenkung zwischen mechanischen Elementen ausgewertet, indem wenigstens eines der mechanischen Elemente zugleich auch Teil eines elektronischen Elements ist, welches ein mit der mechanischen Auslenkung korrelierendes Ausgangssignal bereitstellt. Eine solche Auslenkung kann in der Größenordnung der Strukturen, aus denen das Messelement aufgebaut ist, liegen. Die Auslenkung kann z. B. bestimmt werden, indem eine auslenkungsabhängige Kapazität bestimmt wird.

Beispielsweise kann bei der "Moving Gate" - Technik eine flächige Gate-Elektrode eines Feldeffekttransistors (FET) parallel zu einem Kanal des FET angebracht und relativ zum Kanal ausgelenkt werden. Der Kanal wird durch einen Source- und einen Drainanschluss des Feldeffekttransistors begrenzt. Dabei wird zwischen dem Source- und dem Drainanschluss eine Spannung angelegt und die Gate-Elektrode elektrisch mit dem Drainanschluss verbunden, so dass der Feldeffekttransistor als Stromsteuerung betrieben wird. Ein Stromfluss durch den Feldeffekttransistor ändert sich dann in Abhängigkeit des elektrischen Feldes, welches sich auf Grund der Spannung zwischen der Gate-Elektrode und dem Kanal einstellt. Ändert sich die Anordnung von Gate-Elektrode und Kanal, so ändert sich letztlich auch der Stromfluss durch den Feldeffekttransistor. Die kapazitive Messung bietet sich für MEMS-Messaufnehmer an, da hier praktisch keine Rückwirkung von dem (auslenkungsabhängigen) Stromfluss auf die Auslenkung der Elektrode stattfindet. Gewöhnlich sind die Gate-Elektrode und der Kanal jeweils so geformt, dass ein Bereich, in dem sich die beiden überlappen, zu einer Auslenkung der Gate-Elektrode linear veränderlich ist. Durch die Auslenkung verändert sich die Größe des überlappenden Bereichs, so dass sich das elektrische Feld zwischen Gate-Elektrode und Kanale verändert, welches den Stromfluss durch den Feldeffekttransistor steuert. Somit kann die Auslenkung der Gate-Elektrode anhand des Stromflusses durch den Feldeffekttransistor bestimmt werden.

Das US-Patent 6,220,096 B1 zeigt einen mikroelektromechanischen Beschleunigungssensor, der Moving Gate - Feldeffekttransistoren (MG-FET) der beschriebenen Art in einer differentiellen Verschaltung verwendet, um ein Nutzsignal des Sensors zu optimieren.

Messsysteme, die ein Sensorsignal verarbeiten, sollen üblicherweise ein Ausgangssignal bereitstellen, das in einem möglichst linearen Zusammenhang mit einer zu messenden Größe stehen. Aus diesem Grund werden gewöhnlich alle Elemente des Systems mit linearen Kennlinien ausgelegt, so dass sich über das gesamte System der geforderte lineare Zusammenhang einstellt. Insbesondere bei komplexen, zahlreiche verarbeitende Elemente umfassenden Systemen ist es jedoch schwierig, die Linearität jedes einzelnen Elements in erforderlicher Qualität sicher zu stellen. Der Erfindung liegt daher die Aufgabe zu Grunde, einen MEMS-Sensor bereitzustellen, mit Hilfe dessen eine Erfassung und Auswertung einer Auslenkung verbessert werden kann.

Aus der Schrift US 5,457,368 A ist eine Vorrichtung bekannt, bei dem ein Signal in Abhängigkeit der Belegung eines mit dem Substrat verbundenen und ein elektrisches Feld aufweisenden Bandes erzeugt wird. Das Substrat weist dabei einen Bereich einer Source und einer Drain Region auf, der durch das Band belegt wird.

Aus der Schrift WO 2005/080921 A1 ist ein Positionsdetektor bekannt, bei dem ein mittels eines elektrischen Motor angetriebener erster Aktuator über einen feststehenden zweiten Aktuator bewegt wird. Durch eine Elektrode im ersten Aktuator und Halbleiterelemente im zweiten Aktuator kann so eine Überlappung festgestellt werden.

Aus der Schrift EP 693 672 A1 ist ein Positionssensor bekannt, bei dem eine Abtasteinheit über ein Substrat mit mehreren abwechselnd eingebrachten Sourcee- und Drain-Bereichen bewegt werden kann. Durch die Bewegung der Abtasteinheit über dem Substrat werden unterschiedliche Impulse erzeugt, um bestimmte Positions- bzw.- Referenzmarken zu erfassen

Offenbarung der Erfindung

Diese Aufgabe wird gelöst durch ein Messelement nach Anspruch 1. Ansprüche 8 und 9 geben Messeinrichtungen an, die auf einem solchen Messelement basieren. Anspruch 11 definiert einen Resonator, der auf einer dieser Messeinrichtungen basiert. Unteransprüche geben weitere Ausgestaltungen bzw. Merkmale wieder.

Die Erfindung geht von einem auf einem Feldeffekttransistor basierenden Messelement aus. Das Messelement umfasst einen auf einem Halbleitersubstrat angeordneten Bereich (beispielsweise ein Kanal eines Feldeffekttransistors) und eine Elektrode, mittels derer die Leitfähigkeit des Bereichs beeinflussbar ist. Der Überlappungsbereich zwischen der Gate-Elektrode und dem Bereich weist eine Breite (parallel zur Auslenkungsrichtung) und eine Länge (senkrecht zur Auslenkungsrichtung) auf. Eine Ausdehnung (Fläche) des Überlappungsbereichs ist von der Auslenkung und von den Formen der überlappenden Elemente abhängig. Es wird vorgeschlagen, die Gate-Elektrode und/oder den Bereich derart zu formen, dass die Ausdehnung des überlappenden Bereichs in einem nichtlinearen Zusammenhang mit der Auslenkung der Gate-Elektrode steht. Dies kann dadurch bewirkt werden, dass die Gate-Elektrode und/oder der Bereich eine von einem Rechteck verschiedene Form aufweist.

In einer Ausführungsform kann beispielsweise die Gate-Elektrode eine konventionell rechteckige Form mit parallel bzw. senkrecht zur Auslenkungsrichtung verlaufenden Kanten aufweisen, während der Bereich eine von einem Rechteck verschiedene Form aufweist. Soll das Ausgangssignal symmetrisch zu einem einer Auslenkung von 0 entsprechenden Wert verlaufen, so ist bei rechteckiger Gate-Elektrode der Bereich in positiver Auslenkungsrichtung spiegelbildlich ebenso auszuformen wie in negativer Auslenkungsrichtung. Die Form des Bereichs ist also symmetrisch zu einer senkrecht zur Auslenkungsrichtung und durch eine Auslenkung von 0 verlaufenden Symmetrieachse. In alternativen Ausführungsformen können sowohl die Gate-Elektrode als auch der Bereich auch andere Formen annehmen, insbesondere können die Formen von Bereich und Gate-Elektrode auch vertauscht werden oder sowohl Bereich als auch Gate-Elektrode eine von einem Rechteck verschiedene Form aufweisen. Die Abweichungen von einer konventionellen Form eines Parallelogramms oder eines Rechtecks können größer als fertigungstechnisch bedingt und insbesondere größer als ca. 3-5% sein.

In einer Ausführungsform ist die Gate-Elektrode rechteckig und der Bereich weist eine Form auf, die einem Kreis entspricht, von dem ein oberer und ein unterer Bereich entlang zweier senkrecht zur Bewegungsrichtung der Gate-Elektrode verlaufender Trennlinien entfernt wurden. Diese Ausführungsform eignet sich insbesondere zum Einsatz in einem mikro-elektromechanischen Resonator.

Kurze Beschreibung der Zeichnungen

Die Erfindung wird nun mit Bezug auf die beigefügten Zeichnungen näher beschrieben, wobei

- Fign. 1 a und 1 b unterschiedliche Ansichten eines Messelements auf der Basis eines MG-FETs;
- Fig. 2 eine Messvorrichtung auf der Basis des Messelements aus Fig. 1;
- Fig. 3 ein Diagramm 300 zeigt, welches die Auswirkung der Geometrie des Bereichs 120 aus Fig. 1 in der Messvorrichtung aus Fig. 2, und
- Fig. 4 einen Resonator auf der Basis des Messelements aus Fig. 1 darstellt.

Gleiche bzw. einander entsprechende Elemente tragen in allen Figuren gleiche Bezugszeichen.

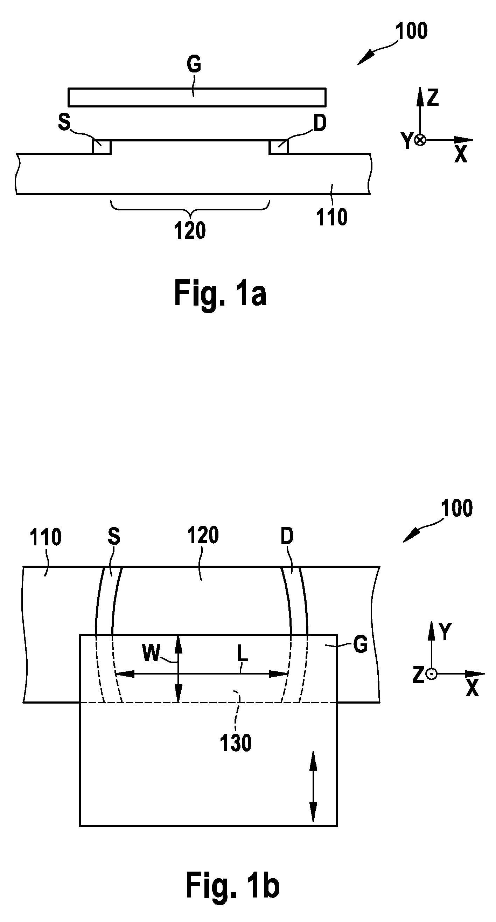

Fign. 1 a und 1 b zeigen zwei unterschiedliche Ansichten eines prinzipiellen Aufbaus eines Messelements 100 nach dem Prinzip eines MG-FETs. Jeweils rechts in den Fign. 1 a und 1 b sind Koordinatensysteme (x, y, z) angegeben, um eine Bezugnahme zu erleichtern. Verdeckte Kanten in Fig. 1b sind mittels unterbrochener Linien dargestellt.
Ein Messelement 100 umfasst ein Halbleitersubstrat 110, auf dem ein Sourceanschluss S und ein Drainanschluss D angebracht sind, zwischen denen sich ein Bereich 120 erstreckt. Das Messelement 100 umfasst außerdem eine oberhalb (in positiver z-Richtung) des Bereichs 120 angebrachte Gate-Elektrode G. Die Gate-Elektrode G ist in positiver und negativer y-Richtung auslenkbar angeordnet. Dabei bleibt ein Abstand zwischen der Gate-Elektrode G und dem Bereich 120 konstant, die Auslenkung findet nur entlang der y-Achse statt.
Nicht dargestellt ist eine elastische Anordnung, welche die Gate-Elektrode in einem vorbestimmten Abstand auslenkbar über dem Bereich 120 hält und Rückstellkräfte bewirkt, die mit der Auslenkung der Gate-Elektrode G in positiver und negativer y-Richtung veränderlich sind. Die elastische Verbindung kann beispielsweise mikromechanische Federn umfassen. In einem Punkt eines Gleichgewichts der Rückstellkräfte der elastischen Verbindung in positiver und negativer y-Richtung befindet sich eine unausgelenkte Position der Gate-Elektrode. In Fig. 1b ist die Gate-Elektrode in dieser unausgelenkten Position dargestellt.
Ebenfalls nicht dargestellt ist eine elektrische Verbindung der Gate-Elektrode G mit dem Drainanschluss D, die beispielsweise die elastische Anordnung umfassen kann. Durch die elektrische Verbindung wird das Messelement 100 stromsteuernd betrieben.
Wird eine Spannung zwischen der Gate-Elektrode G und Sourceanschluss S angelegt, so ermöglicht ein dadurch hervorgerufenes elektrisches Feld im Bereich 120 ein Bewegen von Ladungsträgern zwischen dem Sourceanschluss S und dem Drainanschluss D. Sind die Spannung zwischen der Gate-Elektrode G und dem Sourceanschluss S sowie der vertikale Abstand zwischen der Gate-Elektrode G und dem Bereich 120 konstant, so ist eine Beweglichkeit von Ladungsträgern im Bereich des Bereichs 120 nur von einer Ausdehnung eines Überlappungsbereichs 130 zwischen der Gate-Elektrode G und dem Bereich 120 abhängig. Ein Ausgangssignal der gezeigten Anordnung bestimmt sich grundsätzlich nach $I_{DS} \sim W/L$.
Aus der in Fig. 1b dargestellten unausgelenkten Position kann die Gate-Elektrode G in positiver oder negativer y-Richtung ausgelenkt werden. In der gegebenen Darstellung kann diese Auslenkung fortgeführt werden, bis der Bereich 120 vollständig mit G überlappt bzw. bis die Überlappung den Wert 0 erreicht, andere Grenzen sind ebenfalls implementierbar. Es ist zu erkennen, dass ein nichtlinearer Zusammenhang zwischen einer Auslenkung der Gate-Elektrode G bezüglich des Bereichs 120 und der Ausdehnung des Überlappungsbereichs 130 existiert. Der Überlappungsbereich 130 ist in durch eine in x-Richtung verlaufende Länge L und eine in y-Richtung verlaufende Breite W bestimmt. Dabei ist die Länge L entlang der y-Richtung variabel und in Abhängigkeit der an der jeweiligen y-Stelle geltenden Breite W definiert. Anders ausgedrückt ist der Verlauf der Länge L nichtlinear über den Verlauf der Breite W angegeben.

Die Ausdehnung des Überlappungsbereichs 130 ergibt sich aus seiner Breite W, die proportional zur Auslenkung der Gate-Elektrode G ist, und der Länge L in dessen Verlauf über den Überlappungsbereich 130 (Fig. 1 b). Der Zusammenhang zwischen der Auslenkung der Gate-Elektrode G und der Ausdehnung des Überlappungsbereichs 130 ist nichtlinear, weil L in seinem Verlauf in y-Richtung von W nichtlinear abhängt. Mithin ist der Verlauf der Ausdehnung des Überlappungsbereichs 130 über eine Auslenkung der Gate-Elektrode G nichtlinear und damit auch der Zusammenhang zwischen der Auslenkung und dem Stromfluss durch das Messelement 100 nichtlinear.

Im vorliegenden Beispiel (s. Fig. 1 b) entsprechen die Formen des Sourceanschlusses S und des Drainanschlusses D jeweils einem Kreis- bzw. Ellipsensegment. Der Bereich 120 weist dadurch insgesamt eine Fläche auf, die etwa einem Längsschnitt einer auf der zx-Ebene stehenden Tonne entspricht. Anders ausgedrückt geht die Form des Bereichs 120 aus einem Kreis oder einer Ellipse in der xy-Ebene hervor, von der ein oberes und ein unteres (bzgl. y) Ende abgetrennt wurden, wobei die Trennlinien parallel zur x-Richtung und in gleichem Abstand zur y-Achse an der Stelle y=0 verlaufen. Die Länge L des Bereichs 120 in ihrem Verlauf über die y-Richtung ist beschrieben als:

$$L(y) = \sqrt{L_0^2 - a^2 y^2}$$ , wobei $L_0$ die Länge an der Stelle y=0 definiert und a das Verhältnis der Halbmesser der Ellipse ist (1 im Fall eines Kreises). Um ein Berühren von Sourceanschluss S und Drainanschluss D zu verhindern und um Effekte mit einem sehr kurzen Bereich zu vermeiden ("Kurzkanaleffekte"), darf die Länge L des Bereichs 120 einen kritischen Wert $L_{min}$ nicht unterschreiten. Dies führt dazu, dass der ellipsen- oder kreisförmige Bereich bei $\left| y \right| = \frac{1}{a} \sqrt{L_0^2 - L_{min}^2}$ endet. Die Auslenkung der Gate-Elektrode aus ihrer Ruhelage y=0 sollte vom Betrag her ebenfalls kleiner oder gleich $\frac{1}{a} \sqrt{L_0^2 - L_{min}^2}$ sein, damit der Überlappungsbereich größer oder gleich Null ist und seine Ausdehnung von der Bewegung abhängig bleibt. Im vorliegenden Beispiel ergibt sich aus dieser Forderung für den Bereich 120 die beschriebene Form der beidseitig "gekappten" Ellipse bzw. des beidseitig "gekappten" Kreises.

In weiteren Ausführungsformen kann die Gate-Elektrode auch andere Formen annehmen. Auch ist beispielsweise eine Begrenzung, Verschiebung oder Erweiterung der Auslenkung der Gate-Elektrode G bezüglich des Überlappungsbereichs 130 möglich. Ferner kann die Gate-Elektrode G beispielsweise perforiert sein. Das Messelement 100 kann auch einen weiteren Bereich (nicht dargestellt) aufweisen, der eine Leitfähigkeit einer weiteren Anordnung steuert undebenfalls von der Gate-Elektrode G überstrichen wird. Der weitere Bereich kann mit Bezug auf Fign. 1 a und 1 b beispielsweise in positiver oder negativer x-Richtung angeordnet sein. Die Sourceanschlüsse S und die Drainanschlüsse D der beiden Kanäle können beispielsweise in Serie oder in einer Brückenschaltung miteinander verschaltet sein. Diese und ähnliche, dem Fachmann bekannte Maßnahmen können z. B. dazu verwendet werden, eine Messgenauigkeit zu verbessern, eine Auflösung zu erhöhen und/oder einen vorbestimmten Zusammenhang zwischen dem Ausgangssignal des Messelements 100 mit der Auslenkung von G genauer zu implementieren.

Die Gate-Elektrode G kann auch Teil einer komplexeren mikro-elektromechanischen Anordnung mit mehreren beweglichen Elementen sein. Die Gate-Elektrode G kann mittels einer elastischen Anordnung an einem oder mehreren dieser Elemente und/oder am Halbleitersubstrat 110 befestigt sein, und die beweglichen Elemente können Federn umfassen.

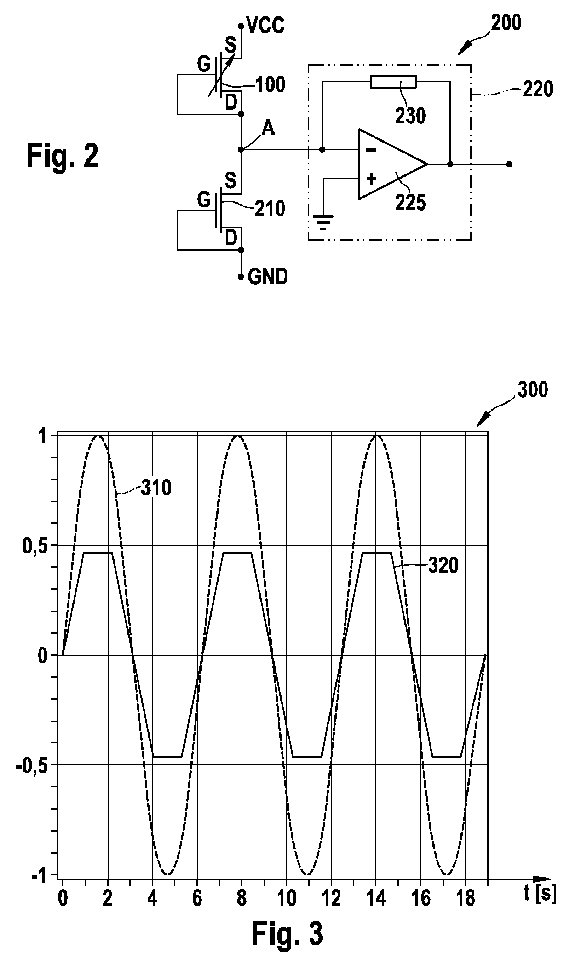

Fig. 2 zeigt eine Messeinrichtung 200, die auf dem Messelement 100 aus Fig. 1 basiert. Die Messeinrichtung 200 umfasst das Messelement 100, ein weiteres Messelement 210 sowie optional eine Einrichtung 220 zur Signalverarbeitung, die einen Operationsverstärker 225 und einen Rückkopplungswiderstand 230 umfasst.

Das Messelement 210 ist grundsätzlich identisch zum Messelement 100 aufgebaut und weist insbesondere identische Abmessungen auf, umfasst jedoch im Gegensatz zum Messelement 100 keine beweglichen Teile. Eine Gate-Elektrode des Messelements 210 ist in einer Position fixiert, die an der Messeinrichtung 100 einer unausgelenkten Position von dessen Gate-Elektrode G entspricht. Bei beiden Messelementen 100 und 210 sind die Gate-Elektroden mit den jeweiligen Drainanschlüssen D verbunden, so dass beide Messelemente 100 und 210 stromsteuernd betrieben werden. Die Messelemente 100 und 210 sind in Serie geschaltet und mit zwei Anschlüssen VCC und GND einer Gleichspannungsquelle (nicht dargestellt) verbunden. Die Messelemente 100 und 210 sind bipolar, daher ist eine Polung der Gleichspannung ohne Belang. An einem Abgriff A zwischen den beiden Messelementen 100 und 210 ist ein Ausgangssignal abgreifbar, welches zur Auslenkung der Gate-Elektrode G im Messelement 100 in einem nichtlinearen Zusammenhang steht.

Durch die Kombination der Messelemente 100 und 210 in der gezeigten Weise werden konstante Fehler, die beispielsweise auf Fertigungsungenauigkeiten der Messelemente 100 und 210 zurückzuführen sind, kompensiert. Die Einrichtung 220 zur Signalverarbeitung erzeugt auf eine dem Fachmann bekannte Weise durch einen mittels des Rückkopplungswiderstands 230 rückgekoppelten Operationsverstärkers 225 aus dem am Abgriff A anliegenden Signal ein mit der Auslenkung der Gate-Elektrode G des Messelements 100 veränderliches Spannungssignal.

Fig. 3 zeigt ein Diagramm 300, welches einen Zusammenhang zwischen einer harmonischen Auslenkung 310 (unterbrochene Linie) der Gate-Elektrode G des Messelements 100 aus den Fign. 1a, 1b und einem Ausgangssignal 320 (durchgezogene Linie) der Einrichtung 220 zur Signalverarbeitung aus Fig. 2 darstellt. In horizontaler Richtung ist ein zeitlicher Verlauf, in vertikaler Richtung eine prozentuale Auslenkung (bzgl. 310) bzw. eine Spannung (bzgl. 320) angetragen.

Es ist zu sehen, dass der Verlauf 310 einer sinusförmigen, harmonischen Auslenkung von G eine Ausgangsspannung 320 bewirkt, die einem symmetrischen Sägezahn bzw. einem Trapez entspricht. Dieser Zusammenhang rührt von der besonderen Form des Bereichs 120 als gekappter Kreis oder gekappte Ellipse, wie in Fig. 1b gezeigt und oben genauer beschrieben ist.

Die sinusförmige, harmonischen Auslenkung 310 kann von einem mikromechanisch aufgebauten Aktuator auf die Gate-Elektrode G übertragen werden. Beispielsweise kann mittels des Messelements 100 aus Fig. 1 mit Hilfe eines kapazitiven, piezo-elektrischen, thermoelastischen oder magnetischen Antriebs ein mikro-elektromechanischer Resonator aufgebaut werden. Entsprechend seiner Verwendung kann der Resonator mehr oder weniger gedämpft sein, beispielsweise durch Gaseinschluss in einem Raum, in welchem die Gate-Elektrode G auslenkbar angeordnet ist.

Der Aktuator und die in Fig. 2 dargestellten Elemente können einen mikro-elektromechanischen Signalgenerator bilden, der sich vielseitig einsetzen lässt. Mit einem solchen Signalgenerator lässt sich durch Variation der Formen der Gate-Elektrode G und/oder des Bereichs 120 eine Reihe verschieden geformter periodischer Signale generieren.

Das Messelement 100 kann vielseitig innerhalb von mikro-elektromechanischen und opto-mikro-elektromechanischen Bauelementen verwendet werden. Insbesondere kann es zusammen mit weiteren Messelementen 100, 210 und/oder einer Einrichtung 220 zur Signalverarbeitung eine Messeinrichtung 200 bilden. Eine Nichtlinearität der Einrichtung 220 zur Signalverarbeitung (und/oder einer anderen Einrichtung zur Signalverarbeitung) kann somit durch die Nichtlinearität des Zusammenhangs zwischen der Auslenkung der Gate-Elektrode G des Messelements 100 und dem Stromfluss durch das Messelement 100 kompensiert werden, so dass insgesamt ein linearer Zusammenhang zwischen der Auslenkung der Gate-Elektrode G gegenüber dem Bereich 120 und dem Ausgangssignal der Einrichtung zur Signalverarbeitung besteht.

Das Messelement 100 bzw. die Messeinrichtung 200 kann zusammen mit anderen mechanischen, optischen und/oder elektronischen Komponenten ein System oder eine Baugruppe bilden. Beispielsweise kann das Messelement 100 Teil eines Initialsensors, eines Drehratensensors oder eines Mikrospiegels sein. In letzterem Fall läge ein opto-mechanisches mikro-elektromechanisches System (Micro-Opto-Mechanical System, MOEMS) vor.

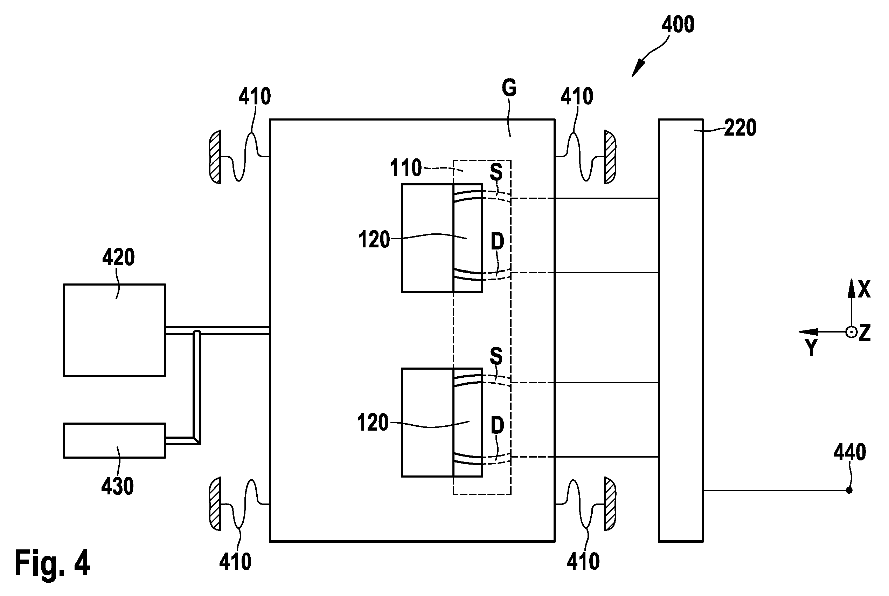

Figur 4 zeigt einen Resonator 400 in einer den Figuren 1a und 1b entsprechenden Darstellung. In Figur 4 rechts ist ein entsprechendes Koordinatensystem angegeben. Der Resonator 400 umfasst ein Substrat 110 mit mehreren Sourceanschlüssen S und Drainanschlüssen D, die paarweise Kanäle 120 begrenzen, eine gemeinsame Elektrode G, eine Verarbeitungseinrichtung 220, Federn 410, einem Antrieb 420, einem Dämpfer 430 und einem Ausgang 440.

Die Verarbeitungseinrichtung 220 ist mit den Sourceanschlüssen S und den Drainanschlüssen D verbunden und bestimmt entsprechend obigen Erläuterungen ein Ausgangssignal, das sie am Ausgang 440 bereitstellt. Die Elektrode G ist mittels der Federn 410 in z-Richtung über den Kanälen 120 angeordnet und kann von dem Antrieb 420 in y-Richtung ausgelenkt werden. Die Elektrode G weist Aussparungen auf, so dass die Kanäle 120 in Abhängigkeit einer Auslenkung der Elektrode G mehr oder minder mit diesen überlappen. Durch die Überlappung der Elektrode G mit mehreren Kanälen 120 kann im dargestellten Resonator 400 eine erhöhte Empfindlichkeit der Auslenkungsmessung erzielt werden.

Wenigstens eine der Federn 410 dient gleichzeitig als elektrischer Kontakt an ein nicht gezeigtes Ankerelement für den Resonator 400, das beispielsweise das Substrat 110 tragen oder mit diesem zusammenfallen kann. Die Auslenkung der Elektrode G wird mittels des Dämpfers 430 gedämpft. Dabei kann es sich z.B. um einen Reibungs- oder Wirbelstromdämpfer handeln oder die Elektrode G kann in einem Behältnis mit einem Gas eines vorbestimmten Drucks eingeschlossen sein. Letztere Variante eignet sich besonders für schwache Dämpfungen, um den Resonator 400 bei einer hohen Güte zu betreiben. Die Dämpfung kann auch durch fluidische Effekte an der verbleibenden beweglichen Struktur und durch Materialdämpfung ("anchor loss") bewirkt werden. Gegebenenfalls wird der Dämpfer 430 weggelassen.

Die Elektrode G kann Teil eines Mikrospiegels oder mit einem solchen verbunden sein. In einem Mikrospiegel-System kann beispielsweise eine tatsächliche Auslenkung der Elektrode G anhand des am Ausgang 440 bereitgestellten Signals bestimmt und der Antrieb 420 entsprechend angesteuert werden, um eine vorbestimmte Auslenkung der Elektrode G zu erzielen. In einer weiteren Ausführungsform kann die Elektrode G Teil eines Inertialsystems sein. Die Auslenkung der Elektrode G kann dann absolut oder in Abhängigkeit einer durch den Antrieb 420 induzierten Auslenkung der Elektrode G bestimmt werden, was Rückschlüsse auf eine Bewegung des Inertialsystems zulässt.

## Patentansprüche

1. Messelement (100), welches ausgelegt ist eine Auslenkung aufzunehmen, folgendes umfassend:

   - einen auf einem Halbleitersubstrat (110) angeordneten Bereich (120), der sich zwischen einem Sourceanschluss (S) und einem Drainanschluss (D) erstreckt, und eine Elektrode (G), welche ausgelegt ist die Leitfähigkeit des Bereichs (120) zu beeinflussen;
   - wobei die Elektrode (G) bezüglich dem Bereich (120) derart auslenkbar angebracht ist, dass sich zwischen der Elektrode (G) und dem Bereich (120) ein Überlappungsbereich (130) ergibt, der eine mit einer Auslenkung der Elektrode (G) veränderliche Ausdehnung aufweist,
   - wobei das Ausgangssignal des Messelements (100) von der Leitfähigkeit des Bereichs (120) abhängt und durch die Änderung der Ausdehnung des Überlappungsbereichs (130) steuerbar ist,
   - der Bereich und/oder die Elektrode derart ausgebildet sind, dass die Änderung der Ausdehnung des Überlappungsbereichs (130) mit der Auslenkung der Elektrode (G) in einem nichtlinearen Zusammenhang steht, so dass eine Änderung des Ausgangssignals des Messelements (100) in einem nichtlinearen Zusammenhang mit der Auslenkung der

   Elektrode (G) steht wobei

   • die Elektrode (G) oberhalb des Bereichs (120) angebracht ist, wobei der Abstand zwischen der Elektrode (G) und dem Bereich (120) konstant bleibt, und
   • eine Oberfläche des Bereichs (120) durch eine in einer Auslenkungsrichtung y der Elektrode (G) verlaufende Breite W und eine senkrecht dazu verlaufende Länge L der Elektrode (G) bestimmt ist und es gilt: $L(y) \approx \sqrt{W^2 - y^2}$ .

2. Messelement (100) nach Anspruch 1, **dadurch gekennzeichnet dass** sich die Elektrode (G) und der Bereich (120) beabstandet angeordnet sind.

3. Messelement (100) nach Anspruch 1, wobei die Länge (L) des Bereichs (120) nicht konstant über die Breite (W) des Bereichs (120) verläuft.

4. Messelement (100) nach einem der vorhergehenden Ansprüche, wobei der Drainanschluss (D) und/oder der Sourceanschluss (S) eine Randlinie des Bereichs (120) in Form eines Ellipsensegments aufweist.

5. Messelement (100) nach Anspruch 1, **dadurch gekennzeichnet dass** der Bereich (120) eine variable Länge L zwischen dem Drainanschluss (D) und dem Sourceanschluss (S) aufweist, wobei für die Länge L in Abhängigkeit von der Auslenkungsrichtung y der Elektrode (G) gilt: $L(y) = \sqrt{L_0^2 - a^2 y^2}$ , wobei $L_0$ die Länge des Bereichs an der Stelle y=0 und a das Verhältnis der Halbmesser der Ellipse angibt.

6. Messelement (100) nach einem der Ansprüche 1 bis 5, wobei der Bereich (120) der Kanal eines Feldeffekttransistors ist und von der Elektrode (G) bei deren Auslenkung zumindest teilweise überstrichen wird.

7. Messelement (100) nach einem der Ansprüche 1 bis 6, wobei die Elektrode (G) perforiert ist.

8. Messelement (100) nach einem der Ansprüche 1 bis 7, wobei die Elektrode (G) Teil eines Mikrospiegels oder eines Inertialsensors ist.

9. Messelement (100) nach einem der Ansprüche 1 bis 8, ferner umfassend ein elastisches Element (410), mittels dessen die Elektrode (G) auslenkbar am Halbleitersubstrat (110) angebracht ist.

10. Messelement (100) nach einem der Ansprüche 1 bis 9 wobei eine Elektrode (G) mehreren Kanälen (120) zugeordnet ist.

11. Resonator (400), umfassend
    ein Messelement (100), welches ausgelegt ist eine Auslenkung aufzunehmen, nach einem der Ansprüche 1 bis 10, und einen Antrieb (420), wobei das Messelement umfasst:

    - einen auf einem Halbleitersubstrat (110) angeordneten Bereich (120)), der sich zwischen einem Sourceanschluss (S) und einem Drainanschluss (D) erstreckt, und eine Elektrode (G), welche ausgelegt ist die Leitfähigkeit des Bereichs (120) zu beeinflussen;
    - wobei die Elektrode (G) bezüglich dem Bereich (120) derart auslenkbar angebracht ist, dass sich zwischen der Elektrode (G) und dem Bereich (120) ein Überlappungsbereich (130) ergibt, der eine mit einer Auslenkung der Elektrode (G) veränderliche Ausdehnung aufweist,
    - wobei das Ausgangssignal des Messelements (100) von der Leitfähigkeit des Bereichs (120) abhängt und durch die Änderung der Ausdehnung des Überlappungsbereichs (130) steuerbar ist,

- der Bereich und/oder die Elektrode derart ausgebildet sind, dass die Änderung der Ausdehnung des Überlappungsbereichs (130) mit der Auslenkung der Elektrode (G) in einem nichtlinearen Zusammenhang steht, so dass eine Änderung des Ausgangssignals des Messelements (100) in einem nichtlinearen Zusammenhang mit der Auslenkung der Elektrode (G) steht

wobei

• die Elektrode (G) oberhalb des Bereichs (120) angebracht ist, wobei der Abstand zwischen der Elektrode (G)und dem Bereich (120) konstant bleibt, und

• eine Oberfläche des Bereichs (120) durch eine in einer Auslenkungsrichtung y der Elektrode (G) verlaufende Breite W und eine senkrecht dazu verlaufende Länge L der Elektrode (G) bestimmt ist und es gilt: $L(y) \approx \sqrt{W^2 - y^2}$ ,

• wobei der Antrieb (420) die Elektrode (G) periodisch auslenkt.

**12.** Resonator (400) nach Anspruch 11, **dadurch gekennzeichnet, dass** wenigstens zwei Messelemente (100) vorgesehen sind, wobei die Messelemente (100) ein gemeinsames Halbleitersubstrat (110) mit mehreren Sourceanschlüssen (S) und Drainanschlüssen (D), die paarweise Bereiche (120) begrenzen, und eine gemeinsame Elektrode (G) aufweisen, wobei eine Verarbeitungseinheit (220) vorgesehen ist, welche mit den den Sourceanschlüssen (S) und den Drainanschlüssen (D) verbunden sind und ein Ausgangssignal in Abhängigkeit von der Auslenkung der Elektrode (G) in Form eines nichtlinearen Zusammenhangs bereitstellt.

**13.** Resonator nach Anspruch 12, **dadurch gekennzeichnet, dass** der Antrieb (420) eine sinusförmige, harmonische Auslenkung (310) auf die Elektrode (G) überträgt, wobei die Verarbeitungseinheit (220) in Abhängigkeit dieser sinusförmigen Auslenkung (310) eine Ausgangsspannung (320) bewirkt, die einen symmetrischen Sägezahn bzw. einem Trapez entspricht..

**Claims**

**1.** Measuring element (100) designed to pick up a deflection, comprising the following:

- a region (120) arranged on a semiconductor substrate (110), said region extending between a source terminal (S) and a drain terminal (D), and an electrode (G) designed to influence the conductivity of the region (120);

- wherein the electrode (G) is fitted in a deflectable fashion relative to the region (120) in such a way that an overlap region (130) results between the electrode (G) and the region (120), said overlap region having an extent that is variable with a deflection of the electrode (G), and

- wherein the output signal of the measuring element (100) is dependent on the conductivity of the region (120) and is controllable by the change in the extent of the overlap region (130),

- the region and/or the electrode are embodied in such a way that the change in the extent of the overlap region (130) is in a non-linear relationship with the deflection of the electrode (G), such that a change in the output signal of the measuring element (100) is in a non-linear relationship with the deflection of the electrode (G),

wherein

• the electrode (G) is fitted above the region (120), wherein the distance between the electrode (G) and the region (120) remains constant, and

• a surface area of the region (120) is determined by a width W - running in a deflection direction y of the electrode (G) - and a length L - running perpendicular thereto - of the electrode (G), and the following holds true:

$$L(y) \approx \sqrt{W^2 - y^2}.$$

**2.** Measuring element (100) according to Claim 1, **characterized in that** the electrode (G) and the region (120) are arranged such that they are spaced apart.

**3.** Measuring element (100) according to Claim 1, wherein the length (L) of the region (120) does not run in a constant fashion over the width (W) of the region (120) .

**4.** Measuring element (100) according to any of the preceding claims, wherein the drain terminal (D) and/or the source terminal (S) have/has an edge line of the region (120) in the form of an ellipse segment.

**5.** Measuring element (100) according to Claim 1, **characterized in that** the region (120) has a variable length L between the drain terminal (D) and the source terminal (S), wherein the following holds true for the length L as a function of the deflection direction y of the electrode (G) :

$$L(y) = \sqrt{L_0^2 - a^2, y^2},$$ wherein $L_0$ indicates the length of the region at the location y=0 and a indicates the ratio of the radii of the ellipse.

6. Measuring element (100) according to any of Claims 1 to 5, wherein the region (120) is the channel of a field effect transistor and is at least partly swept over by the electrode (G) during the deflection thereof.

7. Measuring element (100) according to any of Claims 1 to 6, wherein the electrode (G) is perforated.

8. Measuring element (100) according to any of Claims 1 to 7, wherein the electrode (G) is part of a micromirror or of an inertial sensor.

9. Measuring element (100) according to any of Claims 1 to 8, furthermore comprising an elastic element (410), by means of which the electrode (G) is fitted to the semiconductor substrate (110) in a deflectable fashion.

10. Measuring element (100) according to any of Claims 1 to 9, wherein an electrode (G) is assigned to a plurality of channels (120).

11. Resonator (400), comprising
a measuring element (100) designed to pick up a deflection according to any of Claims 1 to 10, and a drive (420), wherein the measuring element comprises:

- a region (120) arranged on a semiconductor substrate (110), said region extending between a source terminal (S) and a drain terminal (D), and an electrode (G) designed to influence the conductivity of the region (120);
- wherein the electrode (G) is fitted in a deflectable fashion relative to the region (120) in such a way that an overlap region (130) results between the electrode (G) and the region (120), said overlap region having an extent that is variable with a deflection of the electrode (G), and
- wherein the output signal of the measuring element (100) is dependent on the conductivity of the region (120) and is controllable by the change in the extent of the overlap region (130),
- the region and/or the electrode are embodied in such a way that the change in the extent of the overlap region (130) is in a non-linear relationship with the deflection of the electrode (G), such that a change in the output signal of the measuring element (100) is in a non-linear relationship with the deflection of the electrode (G),

wherein

• the electrode (G) is fitted above the region (120), wherein the distance between the electrode (G) and the region (120) remains constant, and
• a surface area of the region (120) is determined by a width W - running in a deflection direction y of the electrode (G) - and a length L - running perpendicular thereto - of the electrode (G), and the following holds true:

$$L(y) \approx \sqrt{W^2 - y^2},$$

• wherein the drive (420) periodically deflects the electrode (G).

12. Resonator (400) according to Claim 11, **characterized in that** at least two measuring elements (100) are provided, wherein the measuring elements (100) have a common semiconductor substrate (110) with a plurality of source terminals (S) and drain terminals (D), which delimit regions (120) in pairs, and a common electrode (G), wherein a processing unit (220) is provided, which is connected to the source terminals (S) and the drain terminals (D) and provides an output signal depending on the deflection of the electrode (G) in the form of a non-linear relationship.

13. Resonator according to Claim 12, **characterized in that** the drive (420) transmits a sinusoidal, harmonic deflection (310) to the electrode (G), wherein the processing unit (220) brings about, depending on said sinusoidal deflection (310), an output voltage (320) corresponding to a symmetrical sawtooth or a trapezium.

**Revendications**

1. Elément de mesure (100) conçu pour enregistrer une déviation, comprenant :

- une région (120) disposée sur un substrat à semiconducteur (110), qui s'étend entre une borne de source (S) et une borne de drain (D), et une électrode (G) conçue pour agir sur la conductivité de la région (120) ;
- dans lequel l'électrode (G) est placée de manière à pouvoir être déviée par rapport à la région (120) afin de créer entre l'électrode (G) et la région (120) une région de chevauchement (130) qui présente un évidement variant avec une déviation de l'électrode (G),
- dans lequel le signal de sortie de l'élément de mesure (100) dépend de la conductivité de la région (120) et peut être commandé par la modification de l'évidement de la région de chevauchement (130),

- la région et/ou l'électrode sont conçues de manière à ce que la modification de l'évidement de la région de chevauchement (130) présente avec la déviation de l'électrode (G) une relation non linéaire de manière à ce qu'une modification du signal de sortie de l'élément de mesure (100) présente une relation non linéaire avec la déviation de l'électrode (G),

dans lequel

- l'électrode (G) est placée au-dessus de la région (120), dans lequel la distance entre l'électrode (G) et la région (120) reste constante, et
- une surface de la région (120) est déterminée par une largeur W s'étendant dans une direction de déviation y de l'électrode (G) et par une longueur L de l'électrode (G) s'étendant perpendiculairement à celle-ci, et la relation suivante est vérifiée : $L(y) \approx \sqrt{W^2 - y^2}$ .

2. Elément de mesure (100) selon la revendication 1, **caractérisé en ce que** l'électrode (G) et la région (120) sont disposées de manière espacée l'une de l'autre.

3. Elément de mesure (100) selon la revendication 1, dans lequel la longueur (L) de la région (120) n'est pas constante sur la largeur (W) de la région (120).

4. Elément de mesure (100) selon l'une quelconque des revendications précédentes, dans lequel la borne de drain (D) et/ou la borne de source (S) présentent une ligne de bord de la région (120) sous la forme d'un segment d'ellipse.

5. Elément de mesure (100) selon la revendication 1, **caractérisé en ce que** la région (120) présente une longueur L variable entre la borne de drain (D) et la borne de source (S), dans lequel, pour la longueur L la relation suivante est vérifiée, en fonction de la direction de déviation y de l'électrode (G):

$$L(y) = \sqrt{L_0^2 \, \Delta a^2 y^2} \; ,$$

où $L_0$ indique la longueur de la région au point y=0 et a indique le rapport des demi-diamètres de l'ellipse.

6. Elément de mesure (100) selon l'une quelconque des revendications 1 à 5, dans lequel la région (120) est le canal d'un transistor à effet de champ et est au moins partiellement recouverte par l'électrode (G) lors de la déviation de cette dernière.

7. Elément de mesure (100) selon l'une quelconque des revendications 1 à 6, dans lequel l'électrode (G) est perforée.

8. Elément de mesure (100) selon l'une quelconque des revendications 1 à 7, dans lequel l'électrode (G) fait partie d'un micro-miroir ou d'un capteur à inertie.

9. Elément de mesure (100) selon l'une quelconque des revendications 1 à 8, comprenant en outre un élément élastique (410) au moyen duquel l'électrode (G) peut être placée de manière à pouvoir être déviée sur le substrat à semi-conducteur (110).

10. Elément de mesure (100) selon l'une quelconque des revendications 1 à 9, dans lequel une pluralité de canaux (120) sont associés à une électrode (G).

11. Résonateur (400), comprenant :

un élément de mesure (100) qui est conçu pour recevoir une déviation selon l'une quelconque des revendications 1 à 10, et un dispositif d'entraînement (420), dans lequel l'élément de mesure comprend :

- une région (120) disposée sur un substrat à semi-conducteur (110), qui s'étend entre une borne de source (S) et une borne de drain (D), et une électrode (G) conçue pour agir sur la conductivité de la région (120) ;
- dans lequel l'électrode (G) est placée de manière à pouvoir être déviée par rapport à la région (120) de afin de créer entre l'électrode (G) et la région (120) une région de chevauchement (130) qui présente un évidement variant avec une déviation de l'électrode (G),
- dans lequel le signal de sortie de l'élément de mesure (100) dépend de la conductivité de la région (120) et peut être commandé par la modification de l'évidement de la région de chevauchement (130),
- la région et/ou l'électrode sont conçues de manière à ce que la modification de l'évidement de la région de chevauchement (130) présente avec la déviation de l'électrode (G) une relation non linéaire de manière à ce qu'une modification du signal de sortie de l'élément de mesure (100) présente une relation non linéaire avec la déviation de l'électrode (G),

dans lequel

- l'électrode (G) est placée au-dessus de la région (120), dans lequel la distance entre l'électrode (G) et la région (120) reste constante, et

- une surface de la région (120) est déterminée par une largeur W s'étendant dans une direction de déviation y de l'électrode (G) et par une longueur L de l'électrode (G) s'étendant perpendiculairement à celle-ci,

et la relation suivante est vérifiée :

$$L(y) \approx \sqrt{W^2 - y^2} \, ,$$

dans lequel le dispositif d'entraînement (420) dévie l'électrode (G) de manière périodique.

**12.** Résonateur (400) selon la revendication 11, **caractérisé en ce qu'**il est prévu au moins deux éléments de mesure (100), dans lequel les éléments de mesure (100) comprennent un substrat à semi-conducteur commun (110) comportant une pluralité de bornes de source (S) et de bornes de drain (D) qui délimitent par paires des régions (120), et une électrode commune (G), dans lequel il est prévu une unité de traitement (220) qui est connectée aux bornes de source (S) et aux bornes de drain (D) et qui fournit un signal de sortie en fonction de la déviation de l'électrode (G) sous la forme d'une relation non linéaire.

**13.** Résonateur selon la revendication 12, **caractérisé en ce que** le dispositif d'entraînement (420) transmet une déviation sinusoïdale harmonique (310) à l'électrode (G), dans lequel l'unité de traitement (220) produit une tension de sortie (320), en fonction de ladite déviation sinusoïdale (310), qui correspond à une dent de scie ou à un trapèze symétrique.

**Fig. 1a**

**Fig. 1b**

Fig. 2

Fig. 3

Fig. 4

**IN DER BESCHREIBUNG AUFGEFÜHRTE DOKUMENTE**

**In der Beschreibung aufgeführte Patentdokumente**

- US 6220096 B1
- US 5457368 A
- WO 2005080921 A1
- EP 693672 A1